Europäisches Patentamt

European Patent Office

Office européen des brevets

(11) Veröffentlichungsnummer: **0 469 314 A2**

## (12) EUROPÄISCHE PATENTANMELDUNG

(21) Anmeldenummer: **91110939.5**

(22) Anmeldetag: **01.07.91**

(51) Int. Cl.5: **H01J 37/02**, H01J 37/20

(30) Priorität: **31.07.90 DE 4024336**

(43) Veröffentlichungstag der Anmeldung:
**05.02.92 Patentblatt 92/06**

(84) Benannte Vertragsstaaten:
**DE FR GB NL**

(71) Anmelder: **SIEMENS AKTIENGESELLSCHAFT**
**Wittelsbacherplatz 2**
**W-8000 München 2(DE)**

(72) Erfinder: **Kolbenschlag, Nikolaus**
**Valpichlerstrasse 6**
**W-8000 München 21(DE)**

(54) **Verfahren zur Entladung einer in einer evakuierten Kammer angeordneten Probe.**

(57) Um nichtleitende Proben (PR) in einem Elektronenstrahlgerät aufladungsneutral untersuchen zu können, wird vorgeschlagen, die durch den abtastenden Elektronenstrahl aufgebrachte Ladung mit Hilfe der in einem Metallplasma vorhandenen Ladungsträger zu neutralisieren. Das Plasma erzeugt man durch eine Gasentladung zwischen zwei in der evakuierten Probenkammer (KA) angeordneten Elektroden (A, K). Eine dieser Elektroden (K) besitzt einen geschichteten Aufbau (Metall-Isolator-Metall), der die Zündung der Gasentladung durch einen Hochspannungsimpuls erleichtert.

EP 0 469 314 A2

Die Erfindung bezieht sich auf ein Verfahren zur Entladung einer in einer evakuierten Kammer angeordneten Probe.

In allen Bereichen der Entwicklung und Fertigung mikro- und optoelektronischer Bauelemente besteht ein steigender Bedarf an Rasterelektronenmikroskopen, um Submikrometerstrukturen visuell beurteilen, Abweichungen von Sollmustern feststellen und topographische Parameter wie Höhen, Breiten oder Neigungswinkel erfassen und auswerten zu können. Konventionelle Rasterelektronenmikroskope erreichen die geforderte Ortsauflösung von Bruchteilen eines Mikrometers bis hin zu wenigen Nanometern allerdings erst bei hohen Beschleunigungsspannungen oberhalb von etwa 20 kV, wo Resiststrukturen und integrierte Schaltungen durch die hochenergetischen Elektronen geschädigt und nichtleitende Proben aufgeladen werden.

Zur Erzeugung einer ausreichend hohen Oberflächen- bzw. Volumenleitfähigkeit werden nichtleitende Proben üblicherweise mit einer dünnen Metallschicht bedampft. Eine Metallisierung der Oberfläche kommt allerdings nicht in Betracht, wenn man die Probe nach ihrer Untersuchung im Rasterelektronenmikroskop wiederverwenden oder einer Weiterbehandlung unterziehen will.

Um auch nicht bedampfbare Proben aufladungsneutral abbilden und untersuchen zu können, wird versucht, die Energie der Elektronen der sogenannten Neutralpunktenergie des Probenmaterials anzugleichen. Da diese im allgemeinen nicht genau bekannt ist, kommt es immer wieder zu lokalen Aufladungen, die den Elektronenstrahl beeinflussen und die Ortsauflösung verringern.

Aus IBM Technical Disclosure Bulletin, Vol. 27, No. 11 (1985), Seiten 6388 bis 6389 ist ein Verfahren zur Entladung eines in einem Elektronenstrahlschreiber strukturierten Halbleiterwafers bekannt. Die Ableitung der durch die Elektronensonde aufgebrachten Ladungen erfolgt hierbei über eine photoleitende Schicht, die man durch Bestrahlung des Wafers mit UV-Licht erzeugt.

Weiterhin ist bekannt, die auf einer Probe vorhandene Ladung mit Hilfe eines auf die Probenoberfläche gerichteten Elektronen- oder Ionenstrahls abzubauen (s. beispielsweise US-A 4 249 077 und Nuclear Instruments and Methods 149, 1978, Seiten 587 bis 590). Bei dem in J. Phys. D: Applied Physics, Vol. 11, 1978, Seiten 2315 bis 2325 beschriebenen Verfahren erzeugt man die der Neutralisierung der Probenladung dienenden Stickstoffionen durch Elektronenstoß in einem oberhalb der Probe aufgebauten elektrischen Feld.

Der Erfindung liegt die Aufgabe zugrunde, ein Verfahren der eingangs genannten Art anzugeben, das eine schnelle Entladung großflächiger Proben erlaubt. Diese Aufgabe wird erfindungsgemäß durch ein Verfahren mit den Merkmalen des Patentanspruchs 1 gelöst.

Der mit der Erfindung erzielbare Vorteil besteht insbesondere darin, daß auch großflächige Proben, insbesondere Leiterplatten mit Abmessungen von beispielsweise 13 x 13 cm² innerhalb kürzester Zeit vollständig entladen werden können.

Die abhängigen Ansprüche betreffen vorteilhafte Weiterbildungen der im folgenden anhand der Zeichnungen näher erläuterten Erfindung. Hierbei zeigt

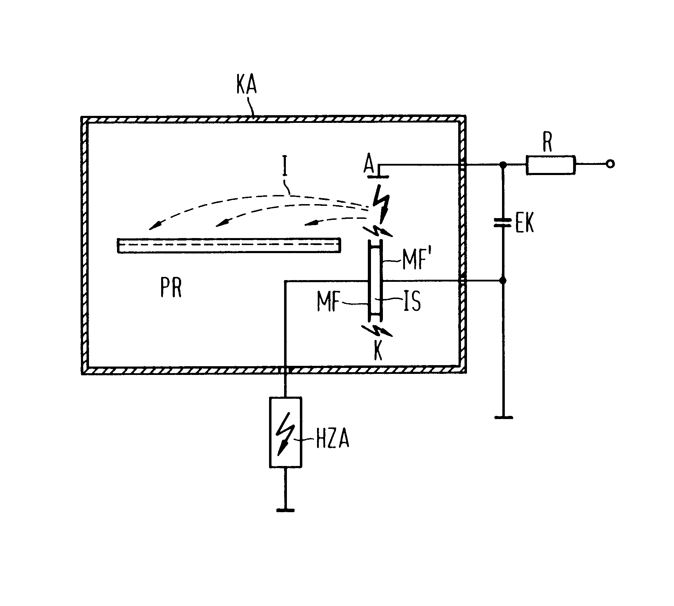

Fig. 1 den schematischen Aufbau einer Vorrichtung zur Durchführung des Verfahrens.

Das erfindungsgemäße Verfahren nutzt eine Gasentladung im Hochvakuum, um die der Neutralisierung der Probenladung dienenden Ionen und Elektronen zu erzeugen. Die Gasentladung erfolgt zwischen zwei in der evakuierten Probenkammer KA ($p \lesssim 10^{-4}$ - $10^{-6}$ Torr) angeordneten Elektroden A/K, wobei die als Kathode dienende Elektrode K aus zwei Kupfer- oder Silberfolien MF, MF' und einem zwischen den Folien angeordneten Isolator IS besteht. Der geschichtete der Aufbau der Elektrode K gewährleistet, daß der mit einer konventionellen KFZ-Zündanlage HZA erzeugte Spannungsimpuls zu einem die Gasentladung auslösenden Funkenüberschlag zwischen der mit der Zündanlage HZA verbundenen und der auf Masse liegenden Metallfolie MF bzw. MF' führt. Die zwischen den etwa 1 bis 10 mm voneinander entfernten Elektroden A bzw. K stattfindende Gasentladung erzeugt ein die Kammer KA ausfüllendes Metallplasma, das genügend Ionen und Elektronen enthält, um auch großflächige Proben PR innerhalb kürzester Zeit vollständig zu entladen.

Als Spannungsquelle für die Anode A (Anodenspannung $U_A$ = + 50 bis + 500 Volt) kommt insbesondere ein schaltfester Kondensator EK in Betracht, dessen Kapazität die Anzahl der im Plasma freigesetzten Ladungsträger I und damit die zur Entladung der Probe PR erforderliche Zeit bestimmt. Zur Aufladung des Kondensators EK verwendet man ein Netzgerät, dem ein Schutzwiderstand R vorgeschaltet ist.

In Versuchen konnte gezeigt werden, daß drei bis vier Entladungen des Kondensators EK (Kapazität C = 100 $\mu$ F, $U_{EK}$ = 100 Volt) ausreichen, um die durch einen Elektronenstrahl aufgebrachte Ladung einer etwa 13 x 13 cm² großen Leiterplatte zu neutralisieren. Der durch das Plasma hervorgerufene Anstieg des Kammerdrucks ist nur von kurzer Dauer, da der Metalldampf sehr schnell kondensiert. Bei jedem Entladevorgang wird Anoden- und Kathodenmaterial verdampft. Der Materialverlust ist bei nicht zu großen Kondensatorkapazitäten C $\lesssim$ 1000 $\mu$ F allerdings so gering, daß man die Elektroden erst nach mehreren Tausend Entladevorgängen austauschen muß.

Die Erfindung ist selbstverständlich nicht auf die beschriebenen Ausführungsbeispiele beschränkt. So kann man anstelle von Kupfer oder Silber auch andere Metalle zur Herstellung der Kathodenfolien MF, MF' verwenden, sofern diese Metalle eine gute Wärmeleitfähigkeit und eine für die während der Gasentladung auftretenden Elektrodentemperaturen ausreichende Stabilität aufweisen.

Um eine Schädigung der in der Probenkammer eines Rasterelektronenmikroskops, Elektronenstrahlmeßgeräts oder Ionenstrahlgeräts vorhandenen Detektoren durch den bei der Gasentladung auftretenden Lichtblitz zu vermeiden, sollten diese während des Entladevorgangs ausgeschaltet werden.

**Patentansprüche**

1. Verfahren zur Entladung einer in einer evakuierten Kammer (KA) angeordneten Probe (PR),
   **dadurch gekennzeichnet,**
   daß in der Kammer (KA) ein Plasma durch Zündung einer Gasentladung erzeugt wird.

2. Verfahren nach Anspruch 1,
   **dadurch gekennzeichnet,**
   daß ein Metallplasma erzeugt wird.

3. Verfahren nach Anspruch 1 oder 2,
   **dadurch gekennzeichnet,**
   daß die Gasentladung durch einen Hochspannungsfunken gezündet wird.

4. Verfahren nach einem der Ansprüche 1 bis 3,
   **dadurch gekennzeichnet,**
   daß die Gasentladung zwischen zwei Elektroden (A, K) gezündet wird, wobei die Potentialdifferenz zwischen den Elektroden (A, K) 50 bis 500 Volt beträgt.

5. Verfahren nach einem der Ansprüche 1 bis 4,
   **dadurch gekennzeichnet,**
   daß eine Elektrode (K) verwendet wird, die einen geschichteten Aufbau der Form Metall-Isolator-Metall aufweist.

6. Verfahren nach Anspruch 5,
   **dadurch gekennzeichnet,**
   daß eine der Metallschichten (MF) mit einer Hochspannungszündanlage (HZA) verbunden wird.

7. Verfahren nach einem der Ansprüche 1 bis 6,
   **dadurch gekennzeichnet,**
   daß die Gasentladung periodisch gezündet wird.

8. Vorrichtung zur Durchführung des Verfahrens nach Anspruch 1,
   **gekennzeichnet durch** eine in der Kammer (KA) angeordnete erste und eine zweite Elektrode (A, K) wobei eine der Elektroden (K) einen geschichteten Aufbau der Form Metall-Isolator-Metall aufweist, eine Hochspannungszündanlage (HZA) zur Erzeugung eines die Gasentladung auslösenden Funkens und einer Einrichtung (EK) zur Erzeugung einer Potentialdifferenz ($U_{EK}$) zwischen der ersten und der zweiten Elektrode (A, K).